# EUROPEAN PATENT SPECIFICATION

(11) **EP 3 444 843 B1**
(45) Date of publication and mention of the grant of the patent: **30.12.2020**
(21) Application number: 17186179.2
(22) Date of filing: 14.08.2017
(51) Int. Cl.: H01L 27/146

(54) **ASSEMBLY FOR DETECTING ELECTROMAGNETIC RADIATION AND METHOD OF PRODUCING AN ASSEMBLY FOR DETECTING ELECTROMAGNETIC RADIATION**
ANORDNUNG ZUR DETEKTION VON ELEKTROMAGNETISCHER STRAHLUNG UND VERFAHREN ZUR HERSTELLUNG EINER ANORDNUNG ZUR DETEKTION VON ELEKTROMAGNETISCHER STRAHLUNG
ENSEMBLE PERMETTANT DE DÉTECTER UN RAYONNEMENT ÉLECTROMAGNÉTIQUE ET PROCÉDÉ DE PRODUCTION D'UN ENSEMBLE DE DÉTECTION DE RAYONNEMENT ÉLECTROMAGNÉTIQUE

(43) Date of publication of application: 20.02.2019
(73) Proprietor: ams International AG, 8645 Jona (CH)
(72) Inventor: FRÖHLICH, Thomas, 8307 Ottikon (CH); LEITNER, Michael, 8047 Kainbach (AT); TROXLER, Thomas, 8703 Erlenbach (CH); PERTL, Josef, 8010 Graz (AT); HOLLINGER, Dominik, 8706 Meilen (CH); MÜLLER, Thomas, 8733 Eschenbach (CH); FITZI, Andreas, 8712 Stäfa (CH); HOFRICHTER, Jens, 8136 Gattikon (CH)
(74) Representative: Epping - Hermann - Fischer

(56) References cited:
- EP-A2- 0 762 504
- EP-A2- 1 168 450
- US-A1- 2008 083 939
- US-A1- 2016 127 668

## Description

The present disclosure is related to the field of detection of electromagnetic radiation, especially X-radiation, by semiconductor devices.

In medical applications of X-radiation, an X-ray tube is employed in combination with a flat panel detector for indirect detection. A scintillator converts X-radiation into visible light, which is then converted by means of photodiodes and readout circuits into a digital code.

A passive type of flat panel detector comprises an array of photodiodes formed in amorphous silicon to generate charge. Each pixel has a thin-film transistor, which is activated to read out the stored charges row by row. Column readout circuits, which are connected to the edge of the panel, convert the charge into a digital code. Large parasitic capacitances and high on-resistances of the thin-film transistors adversely affect the read-out speed and the noise performance of this type of flat panel detector.

Read-out speed and noise performance can be enhanced by integrating the readout circuits on the same wafer together with the pixel array, thus forming an active-pixel sensor. Active-pixel sensors on mono-crystalline silicon comprising complementary metal oxide semiconductor (CMOS) components are employed in cell phone cameras or web cameras, for instance, and are produced using CMOS technology.

US 2008/0083939 A1 discloses a vertically integrated active pixel sensor including a sensor wafer with pixel regions, which is connected to a support circuit wafer. Each pixel region comprises a photosensor, a transfer gate and a charge-to-voltage conversion mechanism. The support circuit wafer includes an interconnect layer and a CMOS device layer with support circuitry, which may especially comprise a source follower transistor, a reset transistor, a row select transistor and a supply voltage for each pixel region, row and column decoders and drivers, sample-and-hold circuits, analog signal processing chains, digital image processing blocks, and memory, timing and control circuits. Electric interconnections and wafer-to-wafer contacts are formed by metal layers that are provided in the interconnect layers.

EP 0 762 504 A2 discloses a photoelectric converter, which has substrates with photoelectric conversion device arrays bonded together to constitute a single photoelectric converter. IC chips with scan circuits and further IC chips with detection integrated circuits are arranged on each of the substrates. The photoelectric conversion devices may comprise a light receiving device, a TFT and a capacitor, which are integrally formed in the photoelectric converter.

US 2016/0127668 A1 discloses imaging devices with sensor panel sections and readout circuit sections. The readout circuit sections are arranged on a base substrate carrying the sensor panel sections. Bonding wires are provided as electric connections.

Active-pixel sensors on amorphous silicon panels are used in some flat panel detectors and result in slight performance improvements over pure passive panels at relatively low cost compared to CMOS active-pixel sensors. However, thin-film transistors in amorphous silicon have the disadvantage of lower transconductance and higher flicker noise compared to transistors on crystalline silicon wafers.

It is an object of the present invention to provide a high-performance wafer-scale imaging sensor at low cost without compromising image quality, especially for X-radiation, and a method of producing such an imaging sensor.

This object is achieved with the assembly for detecting electromagnetic radiation according to claim 1 and with the method of producing an assembly for detecting electromagnetic radiation according to claim 14. Embodiments and variants derive from the dependent claims.

The definitions as described above also apply to the following description unless stated otherwise.

The assembly for detecting electromagnetic radiation comprises a semiconductor device with a main surface, an active-pixel array at the main surface, a readout circuit chip or plurality of readout circuit chips mounted on the main surface outside the active-pixel array, the readout circuit chip or plurality of readout circuit chips being configured to read out voltages or currents provided by the active-pixel array, and electric connections between the active-pixel array and the readout circuit chip or plurality of readout circuit chips.

In an embodiment of the assembly, the semiconductor device comprises a semiconductor wafer, and the active-pixel array is integrated in the wafer. The semiconductor wafer can especially be mono-crystalline.

In a further embodiment the semiconductor wafer has a maximum of four interconnect layers consisting of metal or polysilicon.

In further embodiments the active-pixel array comprises NMOS transistors, PMOS transistors or both NMOS and PMOS transistors. Each pixel of the active-pixel array may be provided with at least three transistors. The number of transistors of each pixel may be limited to twenty active transistors.

Further embodiments comprise further transistors of the readout circuit chip or plurality of readout circuit chips, the transistors of the active-pixel array having a transistor feature size that is at least equal to or larger than the corresponding transistor feature size of the further transistors. The ratio between the transistor feature sizes of the active-pixel array and the readout circuits may even be larger than two.

In an alternative embodiment the active-pixel array comprises transistors in a technology node characterized in that it comprises structures with feature sizes larger or equal to 250 nm.

In further embodiments the electric connections between the active-pixel array and the readout circuit chip or plurality of readout circuit chips comprise solder balls or solder bumps, and/or wires.

Further embodiments comprise a board with electric interconnections, and the semiconductor device is mounted on the board and electrically connected to the electric interconnections. Solder balls or solder bumps and/or wires can be provided for these electric connections. The board may especially be a printed circuit board.

In further embodiments wires electrically connect the semiconductor device to the readout circuit chip or plurality of readout circuit chips and/or to the electric interconnections of the board.

The method of producing an assembly for detecting electromagnetic radiation comprises integrating an active-pixel array on a semiconductor wafer, thus forming a semiconductor device, providing a readout circuit chip or plurality of readout circuit chips, mounting the readout circuit chip or plurality of readout circuit chips on the semiconductor device outside the active-pixel array, and forming electric connections between the active-pixel array and the readout circuit chip or plurality of readout circuit chips.

A mono-crystalline raw wafer can be used in the method as a start material. The active-pixel array is formed at a main surface of the raw wafer. The wafer may be singulated in later processing steps to form individual semiconductor chips or dies. The semiconductor device thus obtained optionally covers more than 30% of the entire original area of the main surface. The semiconductor device may instead cover more than 50% of the surface area.

The semiconductor device can be formed by a CMOS or NMOS or PMOS manufacturing process, for instance.

The following is a detailed description of the assembly and the method in conjunction with the appended figures.
- Figure 1: is a top view of a wafer-scale imaging sensor.
- Figure 2: is a cross section of an assembly of a wafer-scale imaging sensor comprising solder ball connections.
- Figure 3: is a cross section of a further assembly of a wafer-scale imaging sensor comprising connections by solder balls and wires.
- Figure 4: is a cross section of a further assembly of a wafer-scale imaging sensor comprising wire connections.

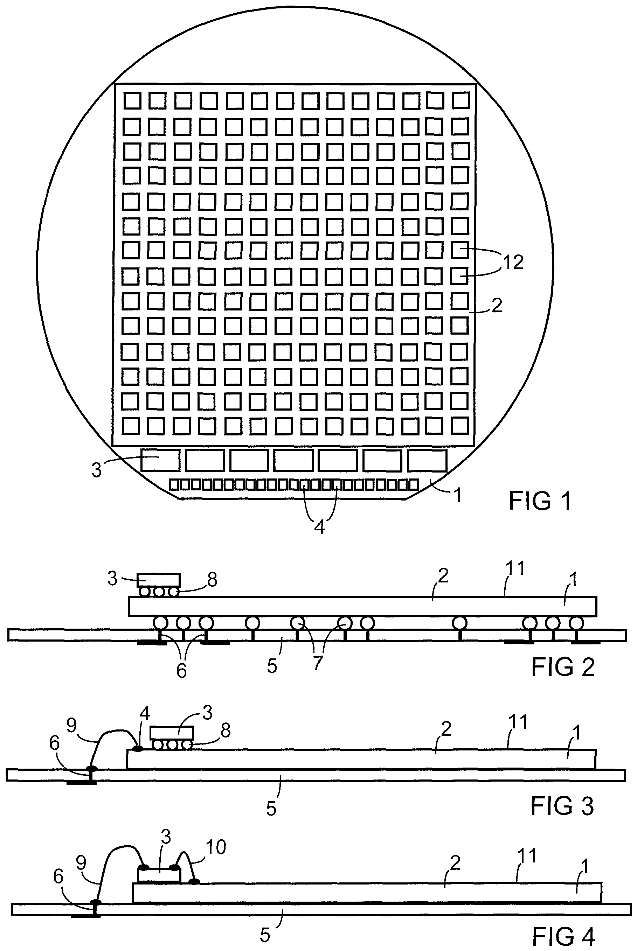

Figure 1 is a top view of a semiconductor device 1 comprising an active-pixel array 2. Each pixel 12 is provided with a photodetector and with an active component, which provides a voltage or current depending on the response of the photodetector to incident radiation. Readout circuit chips 3 are mounted on the periphery of the semiconductor device 1 outside the area of the active-pixel array 2. Bondpads 4 may optionally be provided for external electric connections. The semiconductor device 1 may especially comprise a mono-crystalline wafer, in which the components of the active pixels 12 are integrated.

Figure 2 is a cross section of an embodiment of the assembly. The semiconductor device 1 is mounted on a board 5 with electric interconnections 6. The board 5 may be a printed circuit board, for instance, and may be provided with a backside redistribution layer, which is schematically indicated in Figure 2 by way of example. In the embodiment according to Figure 2, solder balls 7 (or solder bumps) are provided as electric connections between the semiconductor device 1 and the electric interconnections 6 of the board 5. The readout circuit chips 3 are electrically connected to the semiconductor device 1 by further solder balls 8 (or solder bumps).

Figure 3 is a cross section of a further embodiment of the assembly. It differs from the embodiment according to Figure 2 in the electric connections between the semiconductor device 1 and the electric interconnections 6 of the board 5. Wires 9 are provided for the electric connections instead of solder balls. The wires 9 are connected to the bondpads 4 of the semiconductor device 1.

Figure 4 is a cross section of a further embodiment of the assembly. It differs from the embodiments according to Figures 2 and 3 in the electric connections between the semiconductor device 1 and the readout circuit chips 3. Wires 10 are provided for the electric connections instead of solder balls. The wires 10 are connected to the bondpads 4 of the semiconductor device 1. Figure 4 also shows that the electric connections to the electric interconnections 6 of the board 5 may be provided by wires 9 that are electrically connected to the readout circuit chips 3.

In the method of producing the assembly for detecting electromagnetic radiation, an active-pixel array is processed on a semiconductor wafer, in particular on a mono-crystalline wafer, which may be silicon, for instance. In another embodiment, the wafer may be made from gallium arsenide (GaAs). Also, a wafers made from germanium, selenium, indium phosphide or indium gallium arsenide may be contemplated. Each pixel is provided with a photodetector, which may comprise one or more photodiodes, for instance, and at least one active component, in particular one or more transistors, to provide a voltage or current for readout. It may suffice to produce only NMOS transistors and at least two interconnection layers consisting of metal or polysilicon.

Bondpads for final bonding to a printed circuit board can be formed on the same wafer, as well as bondpads for interconnections to the readout circuit chips, according to the embodiments described above. Depending on the die-to-wafer bonding technology that is used to mount the readout circuit chips 3 on the semiconductor device 1, further process steps like plating of bondpads, for instance, may be required.

Semiconductor chips providing the readout circuits, which optionally have mixed-signal properties, can be manufactured in a standard process, especially in a standard CMOS process, especially in silicon. The readout circuits can be simpler than readout circuits for flat panel detectors in amorphous silicon panels, because the pixels are active and therefore provide a voltage or current rather than a charge. Flip-chip assembly or other die-to-wafer bonding technologies, such as wire bonding, for instance, can be used to mount the readout circuit chips 3 to the semiconductor wafer of the semiconductor device 1.

The wafer can then be sawn along boundaries of the active-pixel array 2 to obtain straight edges allowing to closely assemble the semiconductor device 1 to neighbouring devices and thus to form a larger panel. If the active-pixel array 2 covers a rectangular area and the readout circuit chips 3 are arranged near one of the sides of the rectangle, the wafer can be truncated at the three other sides. Optionally, the fourth side, where the readout circuit chips 3 are arranged, can also be sawn to allow easier bonding to the board 5 and to achieve a smaller form factor. In particular, the semiconductor device 1 thus obtained may have lateral dimensions that extend over more than 30% of the main surface area of the original (raw) wafer.

The semiconductor device 1 can be manufactured in a wafer-level low-cost manufacturing process. Standard stepper or scanner lithography can be used, however it is also possible to employ very cost-effective contact or proximity lithography. A CMOS process can be used to produce both NMOS and PMOS transistors, but it may suffice to produce either NMOS transistors or PMOS transistors. The device structures may have a feature size (especially a transistor feature size) larger than 250 nm ("quarter-micron process"), for instance, or a feature size (especially a transistor feature size) larger than 500 nm ("half-micron process"). The photodetectors may be any conventional photodetectors and may especially comprise at least one photodiode, which may comprise an n-implant region and a p-implant region. At least one implant region of the photodiode may be in contact with the main surface 11. The photodiode may be a pinned photodiode, for instance, but also other photodiode variants may be contemplated. For example, also a partially pinned photodiode may be employed.

The readout circuit chips 3 can also be manufactured by a CMOS process. At least one transistor feature size of the readout circuit chips 3 may especially be smaller than a corresponding transistor feature size of the semiconductor device 1. The feature size of the semiconductor device 1 may be at least equal to the corresponding feature size of the readout circuit chips 3. Instead, the ratio of the feature size of the semiconductor device 1 and the corresponding feature size of the readout circuit chips 3 may be larger than two.

The method may be implemented e. g. by an assembly according to the embodiments described above.

The assembly can especially be used in an X-ray detector, and in particular for imaging in medical applications.

The described wafer-scale sensor enables to improve the performance of the entire imaging system, compared to the use of thin-film transistors in amorphous silicon, and to obtain a substantial reduction of the production cost, compared to conventional wafer-scale solutions. If contact or promimixy lithography is employed, the manufacturing process is much more cost-efficient than production methods resorting to stitching.

### List of reference numerals

- 1: semiconductor device
- 2: active-pixel array
- 3: readout circuit chip
- 4: bondpad
- 5: board
- 6: interconnection
- 7: solder ball
- 8: solder ball
- 9: wire
- 10: wire
- 11: main surface
- 12: pixel

## Claims

1. An assembly for detecting electromagnetic radiation, comprising:
a semiconductor device (1) with a main surface (11),
an active-pixel array (2) at the main surface (11), the semiconductor device (1) comprising a semiconductor wafer and the active-pixel array (2) being integrated in the wafer,
a readout circuit chip (3) or plurality of readout circuit chips (3) mounted on the wafer, on the main surface (11) on the periphery of the semiconductor device (1) outside the area of the active-pixel array (2), the readout circuit chip (3) or plurality of readout circuit chips (3) being configured such as to read out voltages or currents provided by the active-pixel array (2), and
electric connections (8, 10) between the active-pixel array (2) and the readout circuit chip (3) or plurality of readout circuit chips (3).

2. The assembly of claim 1, wherein
the semiconductor wafer is mono-crystalline.

3. The assembly of claim 1 or 2, wherein the semiconductor wafer has a maximum of four interconnect layers comprising metal or polysilicon.

4. The assembly of one of claims 1 to 3, wherein
the active-pixel array (2) comprises NMOS transistors, PMOS transistors or both NMOS and PMOS transistors.

5. The assembly of one of claims 1 to 4, wherein
each pixel (12) of the active-pixel array (2) comprises at least three transistors.

6. The assembly of one of claims 1 to 5, wherein
each pixel (12) of the active-pixel array (2) comprises at most twenty active transistors.

7. The assembly of one of claims 4 to 6, further comprising:
further transistors of the readout circuit chip (3) or
plurality of readout circuit chips (3), the transistors of the active-pixel array (2) having a transistor feature size that is at least equal to or larger than a corresponding transistor feature size of the further transistors.

8. The assembly of one of claims 4 to 6, further comprising:
further transistors of the readout circuit chip (3) or
plurality of readout circuit chips (3), the transistors of the active-pixel array (2) having a transistor feature size that is at least twice as large as the corresponding transistor feature size of the further transistors.

9. The assembly of one of claims 1 to 8, wherein
the electric connections (8, 10) between the active-pixel array (2) and the readout circuit chip (3) or plurality of readout circuit chips (3) comprise solder balls (8).

10. The assembly of one of claims 1 to 8, wherein
the electric connections (8, 10) between the active-pixel array (2) and the readout circuit chip (3) or plurality of readout circuit chips (3) comprise wires (10).

11. The assembly of one of claims 1 to 10, further comprising:
a board (5) with electric interconnections (6), the semiconductor device (1) being mounted on the board (5) and electrically connected to the electric interconnections (6).

12. The assembly of claim 11, further comprising:
solder balls (7) or solder bumps electrically connecting the semiconductor device (1) to the electric interconnections (6) of the board (5).

13. The assembly of claim 11 or 12, further comprising:
wires (9, 10) electrically connecting the semiconductor device (1) to the readout circuit chip (3) or plurality of readout circuit chips (3) and/or to the electric interconnections (6) of the board (5).

14. A method of producing an assembly for detecting electromagnetic radiation, comprising:
integrating an active-pixel array (2) in a semiconductor wafer, thus forming a semiconductor device (1),
providing a readout circuit chip (3) or plurality of readout circuit chips (3),
mounting the readout circuit chip (3) or plurality of readout circuit chips (3) on the wafer, on the periphery of the semiconductor device (1) outside the area of the active-pixel array (2), and
forming electric connections (8, 10) between the active-pixel array (2) and the readout circuit chip (3) or plurality of readout circuit chips (3).

15. The method of claim 14, wherein
a mono-crystalline wafer is used as the semiconductor wafer, and
the semiconductor device (1) is formed covering more than 30% of an entire area of a main surface (11) of the wafer.

16. The method of claim 14 or 15, wherein
the semiconductor device (1) is formed by a CMOS process.

17. The method of claim 14 or 15, wherein
the semiconductor device (1) is formed by a NMOS process.

18. The method of claim 14 or 15, wherein
the semiconductor device (1) is formed by a PMOS process.

19. The method of one of claims 14 to 18, wherein
contact or promimixy lithography is employed in the manufacturing process.

## Patentansprüche

1. Anordnung zum Erfassen elektromagnetischer Strahlung, umfassend:
ein Halbleiterbauteil (1) mit einer Hauptfläche (11),
ein Aktivpixel-Array (2) an der Hauptfläche (11), wobei das Halbleiterbauteil (1) einen Halbleiter-Wafer umfasst und das Aktivpixel-Array (2) in den Wafer integriert ist,
einen Ausleseschaltungs-Chip (3) oder mehrere Ausleseschaltungs-Chips (3), der bzw. die auf dem Wafer auf der Hauptfläche (11) am Umfang des Halbleiterbauteils (1) außerhalb des Bereichs des Aktivpixel-Arrays (2) angebracht ist bzw. sind, wobei der Ausleseschaltungs-Chip (3) oder die mehreren Ausleseschaltungs-Chips (3) dazu konfiguriert ist bzw. sind, Spannungen oder Ströme auszulesen, die durch das Aktivpixel-Array (2) bereitgestellt werden, und
elektrische Verbindungen (8, 10) zwischen dem Aktivpixel-Array (2) und dem Ausleseschaltungs-Chip (3) oder den mehreren Ausleseschaltungs-Chips (3).

2. Anordnung nach Anspruch 1, wobei
der Halbleiter-Wafer monokristallin ist.

3. Anordnung nach Anspruch 1 oder 2, wobei
der Halbleiter-Wafer maximal vier Zusammenschaltungsschichten hat, die Metall oder Polysilicium umfassen.

4. Anordnung nach einem der Ansprüche 1 bis 3, wobei
das Aktivpixel-Array (2) NMOS-Transistoren, PMOS-Transistoren oder sowohl NMOS- als auch PMOS-Transistoren umfasst.

5. Anordnung nach einem der Ansprüche 1 bis 4, wobei
jedes Pixel (12) des Aktivpixel-Arrays (2) mindestens drei Transistoren umfasst.

6. Anordnung nach einem der Ansprüche 1 bis 5, wobei
jedes Pixel (12) des Aktivpixel-Arrays (2) höchstens zwanzig aktive Transistoren umfasst.

7. Anordnung nach einem der Ansprüche 4 bis 6, darüber hinaus umfassend:
weitere Transistoren des Ausleseschaltungs-Chips (3) oder der mehreren Ausleseschaltungs-Chips (3), wobei die Transistoren des Aktivpixel-Arrays (2) eine Transistormerkmalsgröße haben, die zumindest gleich einer entsprechenden oder größer als eine entsprechende Transistormerkmalsgröße der weiteren Transistoren ist.

8. Anordnung nach einem der Ansprüche 4 bis 6, darüber hinaus umfassend:
weitere Transistoren des Ausleseschaltungs-Chips (3) oder der mehreren Ausleseschaltungs-Chips (3), wobei die Transistoren des Aktivpixel-Arrays (2) eine Transistormerkmalsgröße haben, die mindestens zweimal so groß ist wie die entsprechende Transistormerkmalsgröße der weiteren Transistoren.

9. Anordnung nach einem der Ansprüche 1 bis 8, wobei die elektrischen Verbindungen (8, 10) zwischen dem Aktivpixel-Array (2) und dem Ausleseschaltungs-Chip (3) oder den mehreren Ausleseschaltungs-Chips (3) Lotkugeln (8) umfassen.

10. Anordnung nach einem der Ansprüche 1 bis 8, wobei die elektrischen Verbindungen (8, 10) zwischen dem Aktivpixel-Array (2) und dem Ausleseschaltungs-Chip (3) oder den mehreren Ausleseschaltungs-Chips (3) Drähte (10) umfassen.

11. Anordnung nach einem der Ansprüche 1 bis 10, darüber hinaus umfassend:
eine Platine (5) mit elektrischen Zusammenschaltungen (6), wobei das Halbleiterbauteil (1) auf der Platine (5) angebracht und elektrisch an die elektrischen Zusammenschaltungen (6) angeschlossen ist.

12. Anordnung nach Anspruch 11, darüber hinaus umfassend:
Lotkugeln (7) oder Lothöcker, die das Halbleiterbauteil (1) elektrisch an die elektrischen Zusammenschaltungen (6) der Platine (5) anschließen.

13. Anordnung nach Anspruch 11 oder 12, darüber hinaus umfassend:
Drähte (9, 10), die das Halbleiterbauteil (1) elektrisch an den Ausleseschaltungs-Chip (3) oder die mehreren Ausleseschaltungs-Chips (3) und/oder an die elektrischen Zusammenschaltungen (6) der Platine (5) anschließen.

14. Verfahren zum Herstellen einer Anordnung zum Erfassen elektromagnetischer Strahlung, umfassend:
Integrieren eines Aktivpixel-Arrays (2) in einen Halbleiter-Wafer, wodurch ein Halbleiterbauteil (1) ausgebildet wird, Bereitstellen eines Ausleseschaltungs-Chips (3) oder mehrerer Ausleseschaltungs-Chips (3),
Anbringen des Ausleseschaltungs-Chips (3) oder der mehreren Ausleseschaltungs-Chips (3) am Wafer am Umfang des Halbleiterbauteils (1) außerhalb des Bereichs des Aktivpixel-Arrays (2), und
Ausbilden elektrischer Verbindungen (8, 10) zwischen dem Aktivpixel-Array (2) und dem Ausleseschaltungs-Chip (3) oder den mehreren Ausleseschaltungs-Chips (3).

15. Verfahren nach Anspruch 14, wobei
ein monokristalliner Wafer als der Halbleiter-Wafer verwendet wird, und
das Halbleiterbauteil (1) mehr als 30 % einer Gesamtfläche einer Hauptfläche (11) des Wafers bedeckend ausgebildet wird.

16. Verfahren nach Anspruch 14 oder 15, wobei das Halbleiterbauteil (1) durch einen CMOS-Prozess ausgebildet wird.

17. Verfahren nach Anspruch 14 oder 15, wobei das Halbleiterbauteil (1) durch einen NMOS-Prozess ausgebildet wird.

18. Verfahren nach Anspruch 14 oder 15, wobei das Halbleiterbauteil (1) durch einen PMOS-Prozess ausgebildet wird.

19. Verfahren nach einem der Ansprüche 14 bis 18, wobei Kontakt- oder Nähelithografie im Herstellungsprozess eingesetzt wird.

## Revendications

1. Ensemble de détection de rayonnement électromagnétique, comprenant:
un dispositif à semiconducteur (1) présentant une surface principale (11),
une matrice de pixels actifs (2) au niveau de la surface principale (11), le dispositif à semiconducteur (1) comprenant une plaquette à semiconducteur et la matrice de pixels actifs (2) étant intégrée dans la plaquette,
une puce de circuit de lecture (3) ou une pluralité de puces de circuit de lecture (3) montées sur la plaquette, sur la surface principale (11) sur la périphérie du dispositif à semiconducteur (1) à l'extérieur de la zone de la matrice de pixels actifs (2), la puce de circuit de lecture (3) ou la pluralité de puces de circuit de lecture (3) étant configurées de manière à lire des tensions ou courants fournis par la matrice de pixels actifs (2), et
des connexions électriques (8, 10) entre la matrice de pixels actifs (2) et la puce de circuit de lecture (3) ou la pluralité de puces de circuit de lecture (3).

2. L'ensemble de la revendication 1, sachant que la plaquette à semiconducteur est monocristalline.

3. L'ensemble de la revendication 1 ou 2, sachant que la plaquette à semiconducteur présente un maximum de quatre couches d'interconnexion comprenant du métal ou du polysilicium.

4. L'ensemble de l'une des revendications 1 à 3, sachant que la matrice de pixels actifs (2) comprend des transistors NMOS, des transistors PMOS ou à la fois des transistors NMOS et PMOS.

5. L'ensemble de l'une des revendications 1 à 4, sachant que chaque pixel (12) de la matrice de pixels actifs (2) comprend au moins trois transistors.

6. L'ensemble de l'une des revendications 1 à 5, sachant que chaque pixel (12) de la matrice de pixels actifs (2) comprend au plus vingt transistors actifs.

7. L'ensemble de l'une des revendications 4 à 6, comprenant en outre:
des transistors supplémentaires de la puce de circuit lecture (3) ou de la pluralité de puces de circuit de lecture (3), les transistors de la matrice de pixels actifs (2) présentant une taille caractéristique de transistor qui est au moins égale ou supérieure à une taille caractéristique de transistor correspondante des transistors supplémentaires.

8. L'ensemble de l'une des revendications 4 à 6, comprenant en outre:
des transistors supplémentaires de la puce de circuit de lecture (3) ou de la pluralité de puces de circuit de lecture (3), les transistors de la matrice de pixels actifs (2) présentant une taille caractéristique de transistor qui est d'au moins deux fois la taille caractéristique de transistor correspondante des transistors supplémentaires.

9. L'ensemble de l'une des revendications 1 à 8, sachant que les connexions électriques (8, 10) entre la matrice de pixels actifs (2) et la puce de circuit de lecture (3) ou la pluralité de puces de circuit de lecture (3) comprennent des billes de soudure (8).

10. L'ensemble de l'une des revendications 1 à 8, sachant que les connexions électriques (8, 10) entre la matrice de pixels actifs (2) et la puce de circuit de lecture (3) ou la pluralité de puces de circuit de lecture (3) comprennent des fils (10).

11. L'ensemble de l'une des revendications 1 à 10, comprenant en outre:
une carte (5) présentant des interconnexions électriques (6), le dispositif à semiconducteur (1) étant monté sur la carte (5) et connecté électriquement aux interconnexions électriques (6).

12. L'ensemble de la revendication 11, comprenant en outre:
des billes de soudure (7) ou des perles de soudure connectant électriquement le dispositif à semiconducteur (1) aux interconnexions électriques (6) de la carte (5).

13. L'ensemble de la revendication 11 ou 12, comprenant en outre:
des fils (9, 10) connectant électriquement le dispositif à semiconducteur (1) à la puce de circuit de lecture (3) ou à la pluralité de puces de circuit de lecture (3) et/ou aux interconnexions électriques (6) de la carte (5).

14. Procédé de production d'un ensemble de détection de rayonnement électromagnétique, comprenant:
l'intégration d'une matrice de pixels actifs (2) dans une plaquette à semiconducteur, formant de la sorte un dispositif à semiconducteur (1),
la mise à disposition d'une puce de circuit de lecture (3) ou d'une pluralité de puces de circuit de lecture (3),
le montage de la puce de circuit de lecture (3) ou de la pluralité de puces de circuit de lecture (3) sur la plaquette, sur la périphérie du dispositif à semiconducteur (1) à l'extérieur de la zone de la matrice de pixels actifs (2), et
la formation de connexions électriques (8, 10) entre la matrice de pixels actifs (2) et la puce de circuit de lecture (3) ou la pluralité de puces de circuit de lecture (3).

15. Le procédé de la revendication 14, sachant que une plaquette monocristalline est utilisée en tant que la plaquette à semiconducteur, et
le dispositif à semiconducteur (1) est formé de manière à recouvrir plus de 30 % d'une aire entière d'une surface principale (11) de la plaquette.

16. Le procédé de la revendication 14 ou 15, sachant que le dispositif à semiconducteur (1) est formé par un processus CMOS.

17. Le procédé de la revendication 14 ou 15, sachant que le dispositif à semiconducteur (1) est formé par un processus NMOS.

18. Le procédé de la revendication 14 ou 15, sachant que le dispositif à semiconducteur (1) est formé par un processus PMOS.

19. Le procédé de l'une des revendications 14 à 18, sachant que
une lithographie par contact ou par proximité est employée dans le processus de fabrication.
